# EUROPEAN PATENT SPECIFICATION

(11) **EP 1 884 724 B1**
(45) Date of publication and mention of the grant of the patent: **15.10.2008**
(21) Application number: 06425548.2
(22) Date of filing: 31.07.2006
(51) Int. Cl.: F24J 2/07

(54) **Shape-memory actuator device for driving a sun-tracking movement**
Aktuator basierend auf einer Formgedächtnislegierung zum Betrieb einer Einrichtung zum Nachführen des Sonnenstands
Actionneur à mémoire de forme pour un dispositif de poursuite du soleil

(43) Date of publication of application: 06.02.2008
(73) Proprietor: C.R.F. Società Consortile per Azioni, 10043 - Orbassano (Torino) (IT)
(72) Inventor: Alacqua, Stefano, 10043 Orbassano Torino (IT); Capretti, Gianluca, 10043 Orbassano Torino (IT)
(74) Representative: Notaro, Giancarlo

(56) References cited:
- EP-A2- 0 113 098
- EP-A2- 0 744 625
- JP-A- 8 074 476
- JP-A- 58 200 956
- JP-A- 60 205 151
- US-A- 4 309 985

## Description

The present invention relates to a solar generator comprising an actuator device to impart a sun-tracking movement to a movable organ of said solar generator, in which the sun-tracking movement is obtained through at least one shape-memory element activated by the heat generated by solar radiation.

A device of the type indicated above is known for example from JP-A-111 25765.

The purpose of the present invention is to provide a solar generator with a sun-tracking device that is particularly simple and efficient in its operation.

In the light of achieving this purpose, the invention proposes a solar generator having all the characteristics of claim 1.

According to the invention, the sun-tracking movement is achieved by focusing solar radiation onto an increasingly large portion of a shape-memory element.

In a preferred embodiment, the shape-memory element comprises at least one shape-memory wire, an increasing portion of the length of which is struck by solar radiation and that is thus subject to a progressive contraction of its length that causes the desired sun-tracking movement.

In a first solution, the optical means comprises an aligned series of convergent lenses, disposed parallel and adjacent to the shape-memory wire. Furthermore, an optical codifier, comprising an aligned series of sections transparent to radiation alternating with opaque sections that impede the passage of radiation, is interposed between the series of convergent lenses and the shape-memory wire, and predisposed in such a manner that the beam of light leaving each convergent lens is intersected by a respective opaque section for a part that decreases during the day as the position of the sun changes, whereas at the same time an increasing part of the beam of light leaving each convergent lens reaches the shape-memory wire through a respective transparent section, so as to progressively activate the shape-memory wire during the course of the day.

In a second solution, the optical means comprises an aligned series of convergent lenses situated adjacent to and along the shape-memory wire, as well as an aligned series of fins situated adjacent to and along the series of convergent lenses, upstream of these, to enable the solar radiation to reach a progressively increasing part of each convergent lens during the course of the day with the movement of the sun, in such a manner that each convergent lens causes progressive actuation of the shape-memory wire.

In a third solution, the optical means comprises an aligned series of convergent lenses disposed parallel and adjacent to the shape-memory wire, and the shape-memory wire includes a codification, being constituted of a series of shape-memory sections interspersed with sections that are inert to heat and of dimensions such that the beam of light leaving each convergent lens meets an active section of the shape-memory wire for an increasing part during the day, with the movement of the sun.

In the preferred embodiment of the invention, the solar generator comprises a matrix consisting of a number of parallel and aligned rows of photovoltaic cells, wherein said photovoltaic cells of each of said rows are borne by a common base mounted in an oscillating manner with regard to the supporting structure. In correspondence with each of the said photovoltaic cells said base bears a micro-concentrator capable of concentrating the solar radiation onto said photovoltaic cell. In a preferred embodiment said micro-concentrator comprises a dome, for example of plastic material, including at its uppermost part a lens to concentrate the sun's energy onto said photovoltaic cell, said lens presenting for example a Fresnel profile, or a profile as a collimator in total internal reflection, or consisting of microlenses. The actuator device, comprising the shape-memory wire and the aligned series of lenses associated to it, is situated at a distance from or alternatively adjacent to the matrix of micro-concentrators, for example along one side of the matrix, to transmit motion to the micro-concentrators.

Further characteristics and advantages of the invention will be clear in the description that follows with reference to the attached drawings, provided as a simple example without limiting intent, in which:

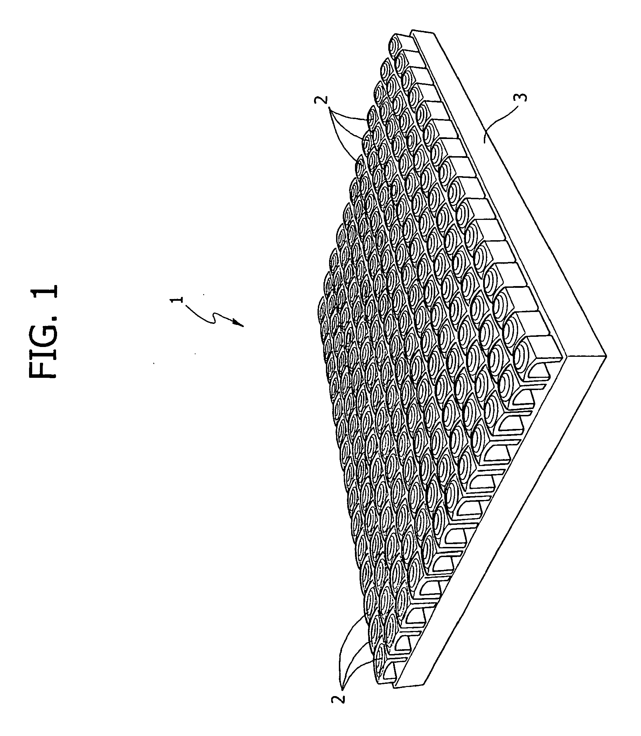

-- figure 1 is a perspective view of a solar generator according to the invention,

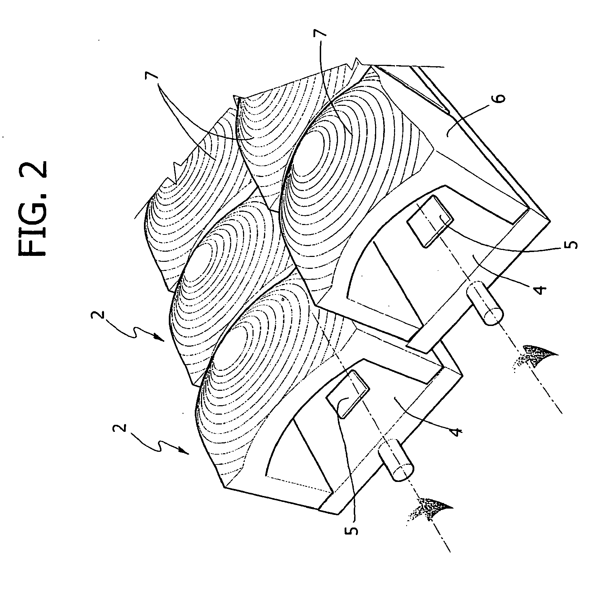

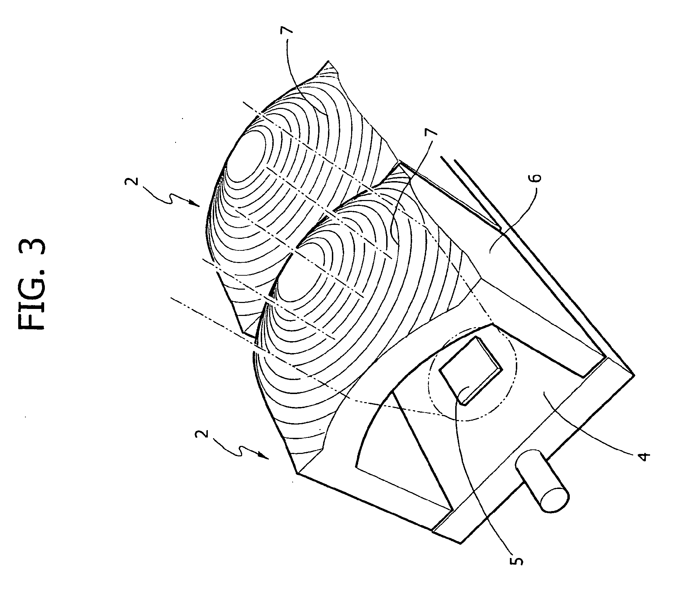

-- figures 2 and 3 are perspective views at an enlarged scale of details of the generator in figure 1,
-- figures 4 and 5 are sections in diagram form showing the movement of the micro-concentrators of the unit in figure 1 as the position of the sun varies,
-- figure 6 is a plan view in diagram form of the unit in figure 1, with an actuator device situated along one of its sides,
-- figures 7A, 7B, 7C and 7D illustrate in diagram form a structure and operating principle of a first embodiment of the actuator device, and
-- figures 8A-8D and 9A-9D illustrate two further variants of embodiment.

In the drawings, numbers 1 and 2 indicate a solar generator unit overall and a detail thereof, comprising a matrix consisting of a number of parallel and aligned rows of photovoltaic cells 5. The photovoltaic cells 5 of each row are borne by a common base 4 mounted in an oscillating manner with regard to the supporting structure 3. In correspondence with each photovoltaic cell 5, the base 4 bears a micro-concentrator 2 consisting of a dome of plastic material 6 including a lens 7 to concentrate the solar energy onto the photovoltaic cell 5.

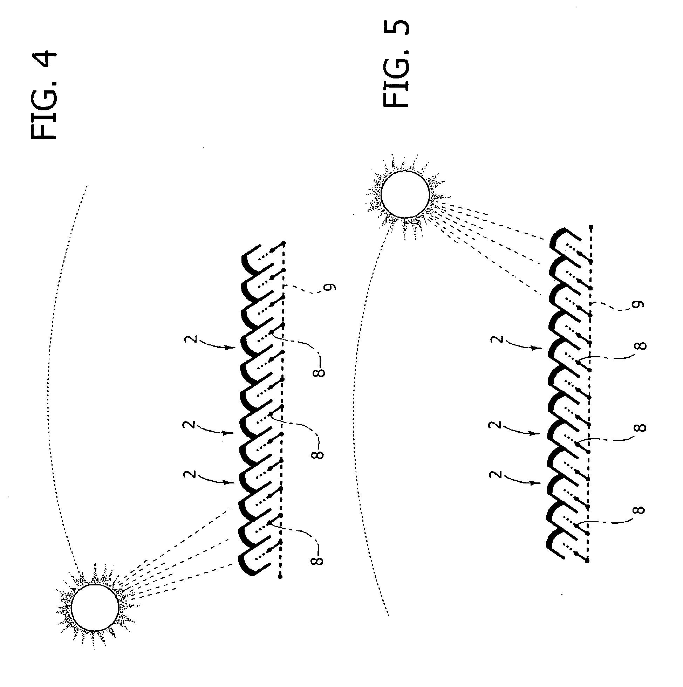

In the embodiment illustrated in diagram form in figures 4 and 5, the simultaneous oscillation of the rows of micro-concentrators 2 around their respective axes of oscillation 8 is driven by an organ acting as a tension member 9, consisting of the shape-memory actuator device. Figures 4 and 5 show the position of the rows of micro-concentrators 2 respectively at the start and end of the day. The device maintains the micro-concentrators 2 aligned at all times with the incident solar radiation, so as to maximise the efficiency of the solar conversion unit.

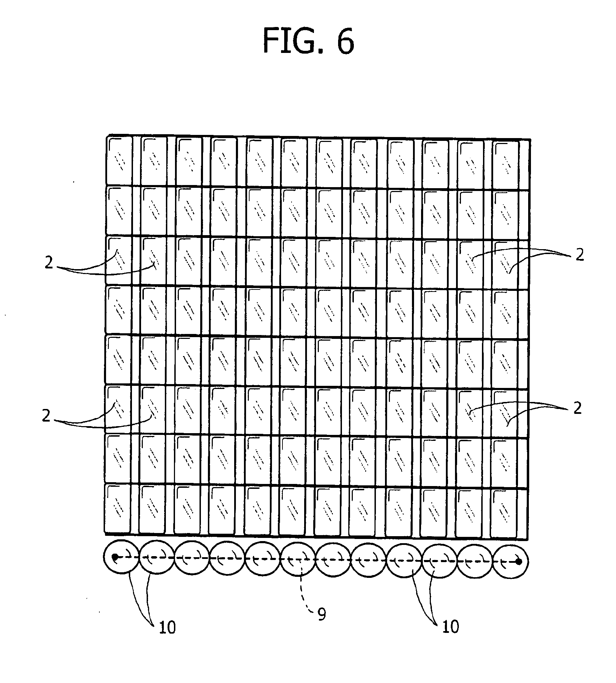

Again in the case of the preferred embodiment illustrated, the shape-memory actuator 9 is predisposed adjacent to one side of the matrix of micro-concentrators 2 (see figure 6) and is overlain by an aligned series of converging lenses 10 disposed adjacent to and along the shape-memory actuator device 9.

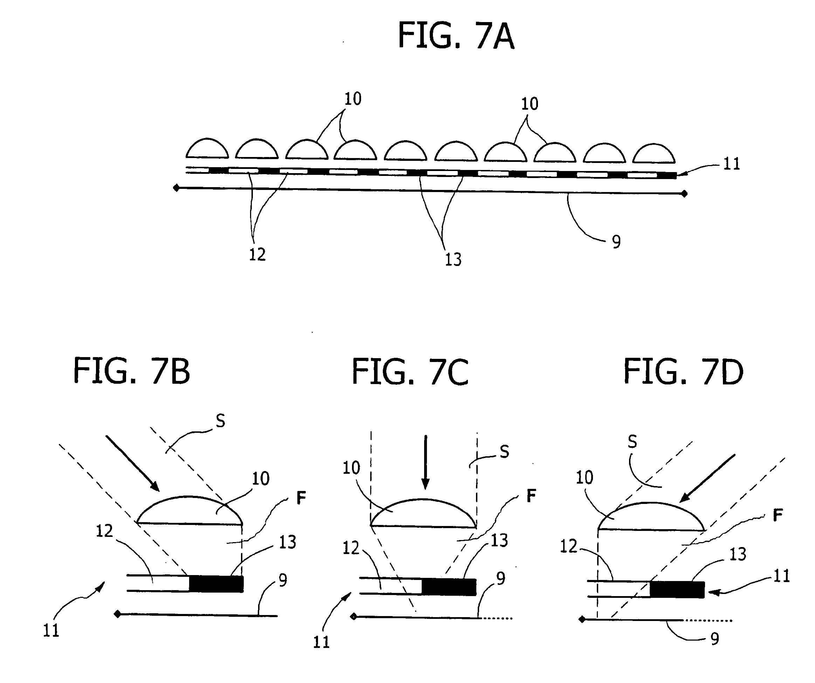

Figures 7A-7D illustrated a first embodiment of the actuator device wherein a shape-memory wire 9 is provided for.

Shape-memory alloys have long been known and used in many different fields. They present the characteristic of passing from a martensitic state to a austenitic state as their temperature varies beyond a certain transition value. In particular it is possible to provide for a shape-memory wire that is subject to progressive contraction of its length when its temperature exceeds a transition value. In the case of the invention, the shape-memory alloy is chosen such that the wire 9 exceeds its transition temperature and is subject to contraction when it is subjected to heating due to the beam of convergent light leaving one of the respective convergent lenses. As already indicated above, an aligned series of convergent lenses 10 is predisposed adjacent and parallel to the shape-memory wire 9.

In the case of the solution in figures 7A to 7D, an optical codifier 11, consisting of an aligned series of sections transparent to the light 12 alternating with opaque sections 13 that stop the light from passing, is situated between the shape-memory wire 9 and the series of convergent lenses 10. The disposition of the convergent lenses 10 and the sections 12, 13 of the optical codifier 11 is such that in the morning the incident solar radiation S is deviated by each lens 10 into a convergent beam F that is completely intercepted by a respective opaque section 13 of the optical codifier 11, so that the shape-memory wire 9 is not activated. As time passes, the portion of the beam F leaving the convergent lens 10 that is intercepted by the opaque section 13 decreases, while an increasing part of the beam F reaches the shape-memory wire 9 through the transparent section 12. In this way, at midday (figure 7C) for example 50% of the beam F leaving the lens 10 reaches the shape-memory wire 9, which therefore begins to be activated. In the afternoon, due to the sun's path, the beam F is completely directed onto the shape-memory wire 9 through the transparent section 12 (figure 7D) so that activation of the shape-memory wire is maximum. This means that the percentage of activation of the shape-memory wire 9 progressively increases from the morning until the evening.

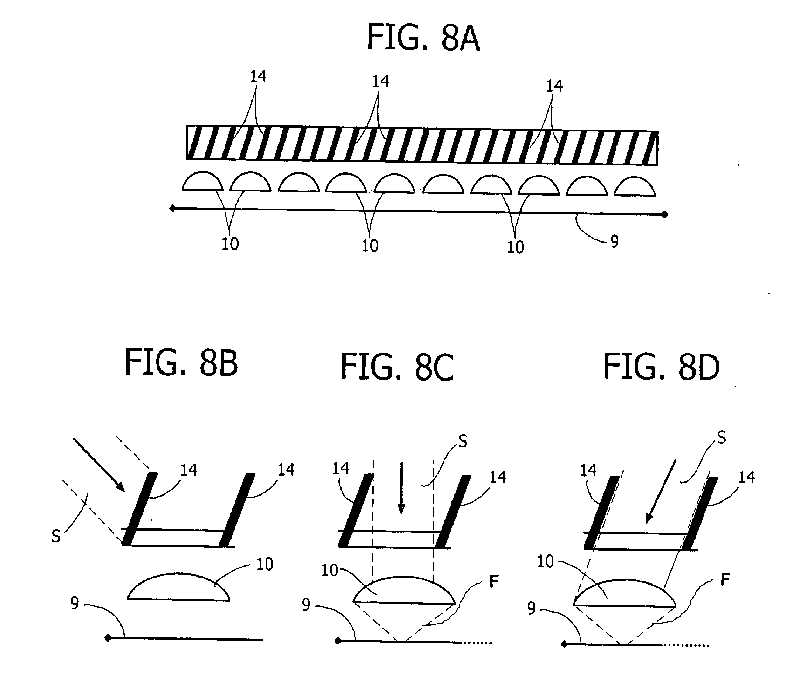

Figures 8A-8D illustrate a variant in which instead of the optical codifying elements 11 interposed between the convergent lenses 10 and the shape-memory wire 9 a series of parallel fins 14 is employed, situated adjacent to and along the aligned series of convergent lenses 10, upstream from them with reference to the direction of the incident solar radiation. The inclination of the fins 14 is such that in the morning each convergent lenses 10 is not illuminated by solar radiation, whereas during the day the portion of each convergent lens 10 that is directly illuminated by solar radiation increases. At midday (figure 8C) the percentage illumination is approximately 50%, whereas in the evening (figure 8D) each lens 10 is completely illuminated. Consequently, the percentage actuation of the shape-memory wire 9 increases progressively from morning to evening.

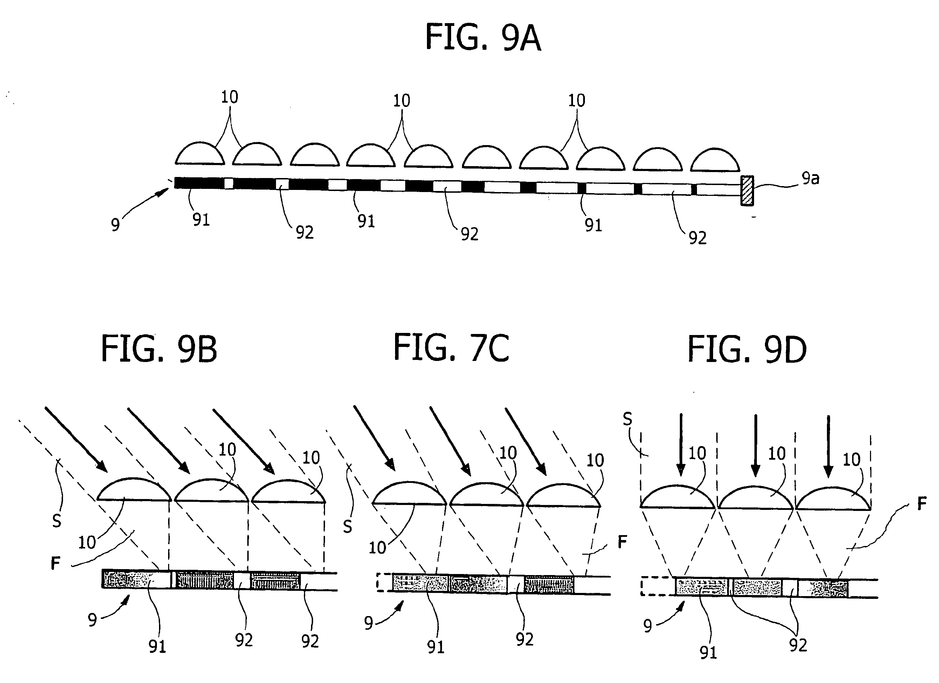

Lastly, the solution shown in figures 9A-9D utilises a shape-memory wire 9 also acting as a codifier. In this case the wire 9, having one extremity 9a fixed, includes a plurality of active shape-memory sections 91 alternating with sections 92 that are inert to heat. As may be seen, the arrangement is such that the length of the active sections 91 progressively increases as their distance from the fixed extremely 9a increases, while the length of the inert sections 92 progressively decreases as their distance along the wire 9 from the fixed extremity 9a increases. The arrangement of the convergent lenses and of the sections 91 and 92 of the wire 9 is such that in the morning all the convergent lenses 10 cause the respective beams of the light leaving them to converge onto the inert sections, whereas only the lens 10 furthest from the fixed extremity 9a (the lens illustrated on the left in figure 9B) partially illuminates a respective active section 91 (figure 9B shows the three lenses furthest to the left of the series of lenses visible in figure 9A). As may be seen, in the morning (figure 9B) only the convergent lens 10 furthest to the left partially illuminates a respective active section 91. During the day, the number of active sections 91 that are increasingly illuminated by their respective convergent lenses increases. Figure 9C shows, with reference to the same three lenses illustrated in figure 9B, that two active sections 91 begin to be activated and a third active section 91 is just about to be illuminated. Figure 9D illustrates the situation with regard to the same three lenses at midday. As the day progress, a situation is reached in which all the convergent lenses 10 cause the beams of light leaving them to converge solely onto active sections 91, in consequence determining a progressive contraction of the entire shape-memory wire 9.

Naturally, whichever solution is chosen, the shape-memory wire 9 may be predisposed in such a way as to have one extremity fixed and the other extremity connected to the mechanical linkage driving the micro-concentrators, such that the progressive contraction of the shape-memory wire during the day imparts a sun-tracking movement to the micro-concentrators. The same mechanical linkage may incorporate elastic means of return that take the system back to its starting condition, as the active condition of the shape-memory device ceases. After the sun sets, as the shape-memory material cools, the device thus automatically returns to its starting condition for a new day.

Naturally, the principle of the invention holding good, the construction details and embodiments may vary widely with regard to what is described and illustrated as a simple example, without thereby departing from the sphere of the present invention.

## Claims

1. Solar generator comprising:
a matrix consisting of a number of parallel and aligned rows of photovoltaic cells,
micro-concentrators capable of concentrating the solar radiation onto said photovoltaic cell, and
a shape-memory actuator device apt to impart a sun-tracking movement to a movable organ of said solar generator, wherein said actuator device comprises at least one shape-memory element (9) activated by heat generated by solar radiation,
said solar generator being **characterised in that** said shape-memory element is situated at a distance from or alternatively adjacent to the matrix of micro-concentrators to-impart to said micro-concentrators (2) said sun-tracking movement, and **in that**
said device comprises optical means (10, 11, 14, 91, 92) to focus the solar radiation onto an increasing portion of the shape-memory element (9) with the movement of the sun, so as to cause a progressive variation of one dimension of the shape-memory element (9) which is transmitted to the micro-concentrators (2).

2. Solar generator according to claim 1, **characterised in that** the shape-memory element is a shape-memory wire subject to a progressive contraction as the temperature increases above a certain transition value.

3. Solar generator according to claim 2, **characterised in that** the optical means comprises an aligned series of convergent lenses arranged parallel and adjacent to the shape-memory wire (9), said optical means being appropriate to vary the portion of the shape-memory element (9) which is illuminated by the beams of convergent light leaving the convergent lenses (10).

4. Solar generator according to claim 3, **characterised in that** said optical means include an element (11) interposed between the shape-memory wire (9) and the aligned series of convergent lenses (10) and comprising an aligned series of sections transparent to the light (12) alternating with opaque sections (13), said sections (12, 13) and said convergent lenses (10) being of such a size and arranged in such a way that the beam of light (F) leaving each convergent lens (10) is intercepted by a respective opaque section (13) for a decreasing part during the day, with the movement of the sun, whereas an increasing part of the beam of light (F) leaving each convergent lens (10) reaches the shape-memory wire (9) through a respective section transparent to the light (12), so as to cause a progressive activation of the shape-memory wire (9).

5. Solar generator according to claim 4, **characterised in that** said optical means include a series of parallel fins (14) disposed parallel to the series of convergent lenses (10) and to the shape-memory wire (9) and upstream from the convergent lenses (10) with reference to the direction of incidence of solar radiation, said fins (14) being of such a size and inclined in such a way that each convergent lens (10) is reached by direct solar radiation for an increasing part during the day, with the movement of the sun.

6. Solar generator to claim 4, **characterised in that** said shape-memory wire (9) comprises a series of active shape-memory sections (91) alternating with sections inert to heat (92), said convergent lenses (10) and said sections (91, 92) of the shape-memory wire (9) being of such a shape and arranged in such a manner that an increasing number of lenses (10) progressively illuminate respective active sections (91) of the shape-memory wire (9) during the day, with the movement of the sun, so as to cause a progressive activation of the shape-memory wire (9).

## Patentansprüche

1. Solargenerator, umfassend:
eine Matrix, die aus einer Anzahl paralleler, ausgerichteter Reihen von Photovoltaikzellen besteht,
Mikrokonzentratoren, die in der Lage sind, die Sonnenstrahlung auf die Photovoltaikzelle zu bündeln, und
eine Betätigungseinrichtung mit Formgedächtnis, geeignet eine Sonnennachführbewegung an ein bewegliches Organ des Solargenerators zu übermitteln, wobei die Betätigungsvorrichtung mindestens ein Formgedächtniselement (9) aufweist, das durch Wärme, die durch Sonnenstrahlung erzeugt wird, aktiviert wird,
wobei der Solargenerator **dadurch gekennzeichnet ist, dass** sich das Formgedächtniselement in einer Entfernung von oder alternativ neben der Matrix von Mikrokonzentratoren befindet, um die Sonnennachführbewegung an die Mikrokonzentratoren zu übermitteln, und dadurch,
dass die Vorrichtung optische Mittel (10, 11, 14, 91, 92) aufweist, um die Sonnenstrahlung auf einen mit der Bewegung der Sonne größer werdenden Abschnitt des Formgedächtniselements (9) zu bündeln, um eine zunehmende Änderung einer Abmessung des Formgedächtniselements (9) zu bewirken, die an die Mikrokonzentratoren (2) übermittelt wird.

2. Solargenerator nach Anspruch 1, **dadurch gekennzeichnet, dass** das Formgedächtniselement ein Formgedächtnisdraht ist, der einer zunehmenden Schrumpfung unterliegt, wenn die Temperatur über einen bestimmten Übergangswert steigt.

3. Solargenerator nach Anspruch 2, **dadurch gekennzeichnet, dass** das optische Mittel eine ausgerichtete Reihe konvergenter Linsen aufweist, die neben dem Formgedächtnisdraht (9) parallel dazu angeordnet sind, wobei das optische Mittel geeignet ist, um den Abschnitt des Formgedächtnisdrahts (9) zu ändern, der von den Strahlen des konvergenten Lichts, das die konvergenten Linsen (10) verlässt, beleuchtet wird.

4. Solargenerator nach Anspruch 3, **dadurch gekennzeichnet, dass** das optische Mittel ein Element (11) aufweist, das zwischen dem Formgedächtnisdraht (9) und der ausgerichteten Reihe konvergenter Linsen (10) eingefügt ist und das eine ausgerichtete Reihe von lichtdurchlässigen Abschnitten (12) aufweist, die sich mit lichtundurchlässigen Abschnitten (13) abwechseln, wobei die Abschnitte (12, 13) und die konvergenten Linsen (10) eine derartige Größe aufweisen und so angeordnet sind, dass das Lichtstrahlenbündel (F), das jede konvergente Linse (10) verlässt, zu einem im Laufe des Tages mit der Bewegung der Sonne abnehmenden Teil von einem jeweiligen lichtundurchlässigen Abschnitt (13) abgefangen wird, während ein größer werdender Teil des Lichtstrahlenbündels (F), das jede konvergente Linse (10) verlässt, den Formgedächtnisdraht (9) über einen jeweiligen lichtdurchlässigen Abschnitt (12) erreicht, um eine allmähliche Aktivierung des Formgedächtnisdrahts (9) zu bewirken.

5. Solargenerator nach Anspruch 4, **dadurch gekennzeichnet, dass** das optische Mittel eine Reihe paralleler Rippen (14) aufweist, die parallel zu der Reihe konvergenter Linsen (10) und zu dem Formgedächtnisdraht (9) und flussaufwärts der konvergenten Linsen (10) mit Bezug auf die Richtung des Einfalls von Sonnenstrahlung angeordnet sind, wobei die Rippen (14) eine derartige Größe aufweisen und derartig geneigt sind, dass jede konvergente Linse (10) im Laufe des Tages mit der Bewegung der Sonne zu einem immer größer werdenden Teil durch direkte Sonnenstrahlung erreicht wird.

6. Solargenerator nach Anspruch 4, **dadurch gekennzeichnet, dass** der Formgedächtnisdraht (9) eine Reihe aktiver Abschnitte (91) mit Formgedächtnis aufweist, die sich mit Abschnitten (92) abwechseln, die neutral gegenüber Wärme sind, wobei die konvergenten Linsen (10) und die Abschnitte (91, 92) des Formgedächtnisdrahts (9) eine derartige Form aufweisen und derartig angeordnet sind, dass eine steigende Anzahl von Linsen (10) im Laufe des Tages mit der Bewegung der Sonne allmählich jeweilige aktive Abschnitte (91) des Formgedächtnisdrahts (9) beleuchtet, um eine zunehmende Aktivierung des Formgedächtnisdrahts (9) zu bewirken.

## Revendications

1. Générateur solaire comprenant :
une matrice contenant un certain nombre de rangées alignées et parallèles de cellules photovoltaïques,
des micro-concentrateurs capables de concentrer le rayonnement solaire sur ladite cellule photovoltaïque, et
un dispositif d'actionnement à mémoire de forme apte à imprimer un mouvement de poursuite du soleil à un organe mobile dudit générateur solaire, dans lequel ledit dispositif d'actionnement renferme au moins un élément à mémoire de forme (9) activé par la chaleur générée par le rayonnement solaire,
ledit générateur solaire étant **caractérisé en ce que** ledit élément à mémoire de forme est situé à une certaine distance de ou bien est alternativement adjacent à la matrice des micro-concentrateurs pour imprimer auxdits micro-concentrateurs (2) ledit mouvement de poursuite du soleil, et **en ce que** ledit dispositif comporte des moyens optiques (10, 11, 14, 91, 92) permettant de focaliser le rayonnement solaire sur une partie croissante de l'élément à mémoire de forme (9) au fur et à mesure du déplacement du soleil, de manière à faire progressivement varier une dimension de l'élément à mémoire de forme (9) transmise aux micro-concentrateurs (2).

2. Générateur solaire selon la revendication 1, **caractérisé en ce que** l'élément à mémoire de forme est un fil métallique à mémoire de forme soumis à une contraction progressive au fur et à mesure de l'augmentation de la température au-dessus d'une certaine valeur de transition.

3. Générateur solaire selon la revendication 2, **caractérisé en ce que** les moyens optiques comprennent une série alignée de lentilles convergentes disposées parallèles et adjacentes au fil métallique à mémoire de forme (9), lesdits moyens optiques étant appropriés pour faire varier la portion de l'élément à mémoire de forme (9) éclairée par les rayons de la lumière convergente partant des lentilles convergentes (10).

4. Générateur solaire selon la revendication 3, **caractérisé en ce que** lesdits moyens optiques renferment un élément (11) interposé entre le fil métallique à mémoire de forme (9) et la série alignée de lentilles convergentes (10) et comportant une série alignée de sections transparentes à la lumière (12) alternant avec des sections opaques (13), lesdites sections (12, 13) et lesdites lentilles convergentes (10) ayant une taille telle et étant disposées de telle manière qu'une partie décroissante au cours de la journée du rayon de lumière (F) partant de chaque lentille convergente (10) est intercepté par une section opaque respective (13), au fur et à mesure du déplacement du soleil, pendant qu'une partie croissante du rayon de lumière (F) partant de chaque lentille convergente (10) atteint le fil métallique à mémoire de forme (9) à travers une section respective transparente à la lumière (12), de manière à activer progressivement le film métallique à mémoire de forme (9).

5. Générateur solaire selon la revendication 4, **caractérisé en ce que** lesdits moyens optiques renferment une série d'ailettes parallèles (14) disposées parallèlement à la série de lentilles convergentes (10) et au fil métallique à mémoire de forme (9) et en amont par rapport aux lentilles convergentes (10) en se référant à la direction d'incidence du rayonnement solaire, lesdites ailettes (14) étant d'une taille telle et inclinées de telle manière qu'une partie croissante au cours de la journée de chaque lentille convergente (10) est atteinte par le rayonnement solaire direct, au fur et à mesure du déplacement du soleil.

6. Générateur solaire selon la revendication 4, **caractérisé en ce que** ledit fil métallique à mémoire de forme (9) comporte une série de sections à mémoire de forme actives (91) alternant avec des sections inertes à la chaleur (92), lesdites lentilles convergentes (10) et lesdites sections (91, 92) du fil métallique à mémoire de forme (9) étant d'une forme telle et disposées de telle manière qu'un nombre croissant de lentilles (10) éclairent progressivement des sections actives respectives (91) du fil métallique à mémoire de forme (9) au cours de la journée, au fur et à mesure du déplacement du soleil, de manière à activer progressivement le fil métallique à mémoire de forme (9).
